Europäisches Patentamt

European Patent Office

Office européen des brevets

(11) Publication number: **0 294 047**

**A1**

(12) **EUROPEAN PATENT APPLICATION**

(21) Application number: **88304320.0**

(22) Date of filing: **12.05.88**

(51) Int. Cl.⁴: **C01B 33/02 , C30B 25/00 , C23C 16/32 , H01L 21/205**

(30) Priority: **14.05.87 US 49478**

(43) Date of publication of application:
**07.12.88 Bulletin 88/49**

(84) Designated Contracting States:
**DE FR GB SE**

(71) Applicant: **DOW CORNING CORPORATION**
**3901 S. Saginaw Road**
**Midland Michigan 48640(US)**

(72) Inventor: **McCormick, James Robert**
**5510 Woodview Pass**
**Midland Michigan(US)**

(74) Representative: **Lewin, John Harvey et al**
**Elkington and Fife High Holborn House 52/54**
**High Holborn**
**London WC1V 6SH(GB)**

(54) Minimizing carbon content of semiconductor materials.

(57) A process for improving the quality of semiconductor materials by minimizing carbon content of these materials is described. The process comprises treating carbonaceous surfaces of a reactor system which come into contact with a hydrogen environment at temperatures of greater than about 500°C. during preparation of the semiconductor materials with silicon carbide, prior to the preparation of the semiconductor materials. Also, described is a semiconductor material of lowered carbon content which is produced by this process.

EP 0 294 047 A1

## MINIMIZING CARBON CONTENT OF SEMICONDUCTOR MATERIALS

The present invention relates to a process for minimizing the carbon content of semiconductor materials. More specifically, the present invention relates to a process for treating carbonaceous surfaces that contact hydrogen at elevated temperatures in the preparation of semiconductor materials or their precursors to minimize the formation of methane gas and other volatile hydrocarbon materials or organosilanes so that the carbon content of the final semiconductor material is minimized.

The ever-increasing demand for improved performance in the electronics field places an ever-increasing demand for improved quality of the semiconductor materials utilized to produce individual components. Since much of the demand for semiconductor materials is directed to semiconductor silicon, the review of the known art prior to the instant invention will be directed to silicon. It is known in the art that carbon impurities in semiconductor silicon can result in inhibition of crystal growth in the conversion of polycrystalline silicon to single crystal silicon. It is known that carbon levels at about 10 to 20 parts per million (ppm) in silicon will stop single crystal growth. It is further known in the art that carbon concentrations as low as a fraction of a part per million in semiconductor silicon are tied to defects in single crystals which lower the yield of devices.

To enhance the final purity of semiconductor silicon, the precursors of semiconductor silicon undergo extensive processing in which purity of the final product is enhanced. Dietz, Keller, and Muhlbauer, Cryst.: Growth, Prop., Appl., 5 (1981), pp. 1-42, summarize a process train leading to crystalline silicon. Carbon and quartz are thermochemically reduced to produce metallurgical grade silicon. Metallurgical grade silicon has a silicon content of approximately 98 weight percent. Raw silicon is converted to trichlorosilane by reaction with hydrogen chloride at a temperature of about $300°C$. The silicon, in the form of liquid trichlorosilane, is further purified by distillation. Distilled trichlorosilane is reduced with hydrogen by the chemical-vapor-deposition process. The polycrystalline silicon obtained now has a purity of 99.9999 weight percent or more at this stage. However, the potential for introduction of carbon impurities can occur at any process step in the train.

Graphite is used as a material of construction for means for heating feeds to the chemical-vapor-deposition process for producing semiconductor silicon. Graphite is also used in equipment for subsequent processing of the semiconductor silicon and in equipment for preparing gaseous or liquid precursors of semiconductor silicon. Graphite is utilized because of its favorable mechanical and chemical properties at elevated temperatures. However, graphite has been found to be a contributor of impurities to semiconductor materials. The inventor of the instant invention believes that the carbon impurities are introduced into semiconductor silicon via the reaction of hydrogen and graphite to form methane and other volatile hydrocarbons and/or organosilanes and the subsequent reaction of these hydrocarbons with the precursor silane material to form an organosilane. The organosilane is then believed to be decomposed, along with the silane, generating semiconductor silicon contaminated with the carbonaceous impurity. It is further believed that carbon from methane and other volatile hydrocarbons and organosilanes can also be incorporated directly into semiconductor silicon during the decomposition of a precursor silane material contaminated with these materials.

It is the objective of the instant invention to improve the quality of semiconductor materials by minimizing the carbon content of the semiconductor material and its precursors. It is a further objective of the instant invention to provide a simple means to accomplish this end.

Tucker in U.S. 3,645,686, issued February 29, 1972, discloses that graphite electrodes utilized in the chemical-vapor-deposition of semiconductor silicon may introduce impurities such as boron, phosphorous, arsenic, and antimony to polycrystalline silicon. Tucker discloses a process to treat the graphite electrodes to minimize the pick-up of these impurities, electron donors and acceptors. Tucker neither suggests nor discloses the treating of the graphite electrodes to minimize the contact of hydrogen with carbonaceous surfaces at elevated temperatures to minimize the formation of methane.

It has been found that at elevated temperatures a reaction occurs between graphite and hydrogen to form methane and other hydrocarbons. It has been further found that methane contamination of hydrogen gas can be correlated to a significant increase in the carbon content of final semiconductor polysilicon from the chemical-vapor-decomposition of a silane and subsequent deposition of silicon. The inventor of the instant invention believe that the carbon is introduced as an organochlorosilane by the reaction of trichlorosilane with methane and other hydrocarbons to generate organochlorosilanes. Decomposition of the organochlorosilanes and deposition of silicon results in semiconductor silicon contaminated with carbon. An example, infra, will demonstrate that these reactions do in fact occur. It has been found that the formation of methane and other hydrocarbons can be reduced dramatically, by as much as 1 to 3 orders of magnitude, by coating graphite surfaces with a protective coating. Further, it was found that the carbon content of polycrystalline semiconductor silicon and subsequent single crystal material is increased significantly with the increase in the methane content of hydrogen fed to a chemical-vapor-decomposition/deposition reactor. Carbon levels in polycrystalline silicon so produced were increased by as much as thirtyfold when methane amounted to as little as 195 ppm in the hydrogen fed to the decomposition/deposition reactor.

Thus, the instant invention provides a simple means to significantly reduce the carbon impurity level in a polycrystalline semiconductor material and subsequent single crystal and recovered precursors of the semiconductor material.

In accordance with the instant invention there is provided a process for minimizing the carbon content of semiconductor materials under conditions that will be delineated herein. What is described, therefore, is a process for improving the quality of semiconductor materials by minimizing carbon content of said materials, said process comprising treating carbonaceous surfaces of a reactor system which come into contact with a hydrogen environment at temperatures of greater than about 500°C. during preparation of said semiconductor materials with silicon carbide, prior to the preparation of said semiconductor materials.

The semiconductor materials can be selected from a group consisting of (i) semiconductor silicon; and (ii) a precursor silane of semiconductor silicon, the precursor silane being selected from a group consisting of silane, dichlorosilane, trichlorosilane, tetrachlorosilane and disilane. The process for preparing semiconductor materials can be such known processes as decomposing a precursor silane of semiconductor silicon with hydrogen in a vapor state and depositing semiconductor silicon on a heated substrate of semiconductor silicon, said substrate being at a temperature greater than about 700°C., wherein the precursor silane is selected from a group consisting of silane, dichlorosilane, trichlorosilane, tetrachlorosilane, and disilane. The process for preparing semiconductor materials can also be the preparation of a precursor of semiconductor silicon such as the known process of reacting tetrachlorosilane with hydrogen at temperatures greater than about 600°C. to produce trichlorosilane, and like processes.

Carbonaceous materials, graphite in particular, are used as materials of construction for processes to produce semiconductor silicon and subsequent processing of the semiconductor silicon and precursor silanes of semiconductor silicon. Graphite is utilized because of its favorable mechanical and chemical properties at elevated temperatures. However, graphite has been found to be a contributor of carbonaceous impurities to semiconductor materials.

Methane is the carbon-containing material of primary concern relative to carbon contamination of semiconductor silicon. However, other volatile hydrocarbon materials are also believed to contribute to carbon contamination. For the purposes of the instant invention "other volatile hydrocarbon materials" means carbon and hydrogen containing materials having boiling points at atmospheric pressure that are lower than ambient temperature. The inventor believes that hydrogen attacks carbonaceous surfaces to form methane and other volatile hydrocarbon materials at significant rates at temperatures as low as 500°C. Thus, carbonaceous surfaces of a reactor system used to produce semiconductor materials that are exposed to a hydrogen environment at temperatures of greater than 500°C. would be subject to attack by hydrogen, forming methane and other volatile hydrocarbon materials.

The inventor of the instant invention believes that carbonaceous impurities are introduced into semiconductor silicon via the reaction of hydrogen and carbon to form methane and the subsequent reaction of methane with the precursor silane material to form an organosilane. The organosilane is then believed to be decomposed, along with the silane, generating semiconductor silicon with carbonaceous impurity.

For the purposes of the instant invention "a material inert to the attack of hydrogen" means a material that will not react with hydrogen at temperatures above 500°C. For the purposes of the instant invention "an essentially non-porous layer of a material" means a layer of minimum thickness which will minimize contact of hydrogen with carbonaceous surfaces to reduce the level of methane generation to less than about 5 percent of the level generated with uncoated carbonaceous surfaces. A preferred material inert to the attack of hydrogen is silicon carbide.

Coatings of silicon carbide can be applied to graphite surfaces by techniques known in the art of coatings. Silicon carbide can be applied to graphite surfaces via processes similar to those described by Bracken et al., in U.S. 3,459,504, issued August 5, 1969; and by Sirtl et al., in German Patent Publication DE 2,739,258, published March 22, 1979, in which the graphite surfaces are treated with a gaseous stream of a silane derivative, such as dimethyldichlorosilane or methyltrichlorosilane, and hydrogen at elevated temperatures to deposit a non-porous coating on said graphite surface.

In accordance with the instant invention, there is also provided a semiconductor material with a lowered carbon content which has been prepared from the process, supra. What is described, therefore, is a semiconductor material produced in a reactor system, the carbonaceous surfaces of said reactor system which come into contact with a hydrogen environment at temperatures of greater than about 500°C. during preparation of said semiconductor materials being treated with silicon carbide, prior to the preparation of said semiconductor materials.

The semiconductor material is selected from a group consisting of (i) semiconductor silicon; and (ii) a precursor silane of semiconductor silicon. The precursor silane of semiconductor silicon is selected from a group consisting of silane, dichlorosilane, trichlorosilane, tetrachlorosilane, and disilane. The semiconductor silicon of the instant invention can be characterized by carbon contents that are lower, by a factor of about 3 to 20 times, than that of semiconductor silicon that has not been prepared by the process of the instant invention.

The following examples are presented to be illustrative of the instant invention and are not to be construed as limiting the instant invention delineated in the claims.


Example 1: (Not within the scope of the instant invention)

Samples of graphite utilized in the construction of heating equipment were exposed to hydrogen gas at an elevated temperature with and without an inert, protective coating. The effluent hydrogen gas was analyzed by known gas chromatographic means.

Five graphite samples were evaluated. These samples, designated as Samples A, B, C, D, and E, respectively, are identified by trade name and vendor in Table 1.


### Table 1

| Sample | Trade Name | Vendor |
|---|---|---|
| A | Stackpole 6300 | The Stackpole Corp., |
| B | Stackpole 6301 | St. Mary's, Pa. |
| C | Toyo-Tanza SIC 12 | Graphite Systems, Inc., Ft. Worth, Texas |
| D | Great Lakes Carbon H-020 | Great Lakes Carbon Corp. Niagara Falls, New York |
| E | Great Lakes Carbon H-020X | |

Two sets of samples of the above graphite materials identified in Table 1 were cut to a maximum dimension of 5/8 inch by 5/8 inch by 4 inches. One set of samples was evaluated uncoated, "as received". The second set of samples was coated with silicon carbide by a vendor, Midland Materials Research, Inc., Midland, Michigan, by the vendor's proprietary process. The specification for the thickness of the silicon carbide coating is in the range of 2 to 25 mils.

The graphite samples that were coated with silicon carbide may have been prepared via means similar to those described by Bracken et al., in U.S. 3,459,504, issued August 5, 1969; and by Sirtl et al., in German Patent Publication DE 2,739,258, published March 22, 1979, in which the graphite surfaces are treated with a gaseous stream of a silane derivative, such as dimethyldichlorosilane or methyltrichlorosilane, and hydrogen at elevated temperatures to deposit a non-porous coating of silicon carbide on said graphite surface.

Both "as received" samples and silicon carbide-coated samples were tested in the same manner. Each graphite sample was placed into a quartz tube, approximately 1 inch in diameter. The quartz tube was fitted with end closures which were fitted with provisions for gas flow and a temperature probe. The quartz tube and sample were placed into an electrically heated tube furnace. The quartz tube was purged with argon to remove air. Once the quartz tube was purged and checked for leaks, a hydrogen gas flow of 370 cubic centimeters per minute (cc./min.) was established. Electric power was applied to the tube furnace. A temperature of about 1100° C. was reached and maintained. The effluent gas from the furnace was passed through a gas chromatographic analyzer to analyze for methane content.

Table 2 is a summary of the methane analyses from the several runs made with the graphite samples, both "as received" and silicon carbide-coated. The samples are designated as in Table 1. The results are reported for both uncoated samples, designated in Table 2 as "Uncoated" and silicon carbide-coated

4

samples, designated as "SiC". The response reported is the methane content of the effluent hydrogen gas in part per million by volume (ppmv).

### Table 2

| Sample | Uncoated | SiC |
|---|---|---|
| A | 2400 | 1 |
| B | 3560 | 20 |
| C | 1270 | 7 |
| D | 2000 | 40 |
| E | 2250 | 23 |

The results of the above example demonstrate that hydrogen will react with graphite surfaces at elevated temperatures to generate methane. The results further demonstrate that the generation of methane is decreased significantly when a graphite surface is coated with silicon carbide.

### Example 2:

A study was conducted in which a mixture of tetrachlorosilane, hydrogen, and methane were contacted at elevated temperature. A quartz tube furnace system and gas analysis techniques similar to those used in Example 1 were used in this study.

All runs were conducted at a temperature of $900^{\circ}$C. A series of three runs was made at varying concentrations of tetrachlorosilane, hydrogen, and methane. Gas flow through the heated quartz tube was maintained at 1100 cc./min. Table 3 is a summary of the gas mixtures utilized in these three runs. The three runs are designated as Samples F, G, and H, respectively. The gas mixtures are characterized by tetrachlorosilane content, designated as "$\%SiCl_4$"; hydrogen content is designated as "$\%H_2$"; and methane content is designated as "$\%CH_4$". Composition of the gas mixture is reported in volume percent.

### Table 3

| Sample | $\%SiCl_4$ | $\%H_2$ | $\%CH_4$ |
|---|---|---|---|
| F | 16.7 | 33.3 | 50.0 |
| G | 20.0 | 20.0 | 60.0 |
| H | 22.2 | 11.1 | 66.7 |

Table 4 is a summary of the analyses of the effluent gas from the heated quartz tube. The results, in volume percent, are percent tetrachlorosilane, designated "$\%SiCl_4$", percent methyldichlorosilane, designated "$\%MeHSiCl_2$", and percent methyltrichlorosilane, designated "$\%MeSiCl_3$".

### Table 4

| Sample | $\%SiCl_4$ | $\%MeHSiCl_2$ | $\%MeSiCl_3$ |
|---|---|---|---|
| F | 9.8 | <0.086 | 2.6 |
| G | 10.7 | <0.02 | 1.1 |
| H | 11.3 | <0.03 | 0.6 |

The results of the above study demonstrate that methane mixed with hydrogen and a chlorosilane can be converted to methylchlorosilanes at elevated temperatures. These results lend support to the belief of the inventor that methylchlorosilanes are a vehicle by which carbon impurities are introduced into semiconductor silicon.

Example 3:

Semiconductor silicon was produced via vapor decomposition/deposition of trichlorosilane using hydrogen gas that had been exposed to a hot graphite surface. The decomposition/deposition reactor was similar to those known in the art. Representative examples of the apparatus and method described above are disclosed in several U.S. patents: U.S. 3,011,877, Schweickert et al., issued December 5, 1961; U.S. 3,099,534, Schweickert et al., issued July 30, 1963; U.S. 3,147,141, Ishizuka, issued September 1, 1964; U.S. 4,150,168, Yatsurugi et al., issued April 17, 1979; U.S. 4,179,530, Koppl et al., issued December 18, 1979; and U.S. 4,311,545, Bugl et al., issued January 19, 1982.

A second decomposition reactor, similar to the above, was assembled using an electrically heated graphite element in place of the standard semiconductor silicon substrate. The flow rate of hydrogen gas through this reactor, with a heated graphite element, was set so that a residence time of about 2 to 3 minutes was maintained. Electric power was controlled so that temperature of the graphite surface was at about 1000° to 1100° C. The effluent hydrogen gas, contacted with a heated graphite surface, was used as the primary hydrogen feed to the decomposition/deposition reactor. Effluent hydrogen gas was analyzed by known gas chromatographic techniques.

Standard decomposition/deposition runs are used as a basis against which the results of this study will be compared. Standard results will be designated as Sample J.

The resultant deposited polycrystalline semiconductor silicon was analyzed for carbon, using known infrared techniques. A sample of the polycrystalline semiconductor silicon was converted into single crystal material using a float-zone refining technique, similar to that disclosed by Theuerer in U.S. 3,060,123, issued October 23, 1962. The single crystal material was also analyzed for carbon. The results of carbon analyses will be reported, infra.

Three runs, designated Samples L, M, and N, respectively, were made in which the hydrogen feed to the decomposition/deposition reactor was first passed through the reactor with graphite heaters. Additionally, during a five-day period of production of semiconductor silicon in a decomposition/deposition reactor, similar to the reactor used in this study, feed hydrogen gas was found to be high in carbon dioxide. These results are reported as Sample P.

Table 5 is a summary of the analyses of the hydrogen gas stream after contact with the heated graphite surface. Also summarized is the analyses of typical hydrogen feed before contact with the heated graphite surface, designated as Sample J and Sample P above. The analyses are reported in ppmv for methane, designated as "$CH_4$", carbon dioxide, designated as "$CO_2$", and carbon monoxide, designated as "CO".

## Table 5

| Sample | $CH_4$ | $CO_2$ | CO |
|--------|--------|--------|------|
| J | 7 | 19 | <1 |
| L | 500 | 10 | 28 |
| M | 170 | <1 | 1 |
| N | 400 | <1 | 8 |
| P | 10 | 134 | <3 |

Table 6 is a summary of the carbon analyses for the polycrystalline and single crystal materials generated in these runs. Typical production history for semiconductor silicon produced in the decomposition/deposition reactor utilized in this study is included as Sample J. The results in Table 6 for Samples L, M, and N are reported relative to the results of Sample J. The carbon analyses for polycrystalline material is designated in Table 6 as "Poly"; float-zone refined single crystal is designated as "Single".

### Table 6

| Sample | Poly | Single |
|--------|------|--------|
| J | 1.0 | 1.0 |
| L | 16.0 | 7.8 |
| M | 3.6 | 3.2 |
| N | 23.2 | 19.8 |

Polycrystalline semiconductor silicon produced during the period of high carbon dioxide levels in hydrogen was analyzed to have as low or lower carbon content than Sample J.

The above results demonstrate that the carbon content of semiconductor silicon produced by the hydrogen reduction of trichlorosilane is increased significantly with the introduction of methane into the hydrogen feed stream. Additionally, the results indicate that higher levels of carbon dioxide do not effect the carbon content of deposited semiconductor silicon. The results further illustrate the formation of methane when hydrogen gas is contacted with a graphite surface at elevated temperatures.

**Claims**

1. A process for improving the quality of semiconductor materials by minimizing carbon content of said materials, said process comprising treating carbonaceous surfaces of a reactor system which come into contact with a hydrogen environment at temperatures of greater than about $500°C.$ during preparation of said semiconductor materials with silicon carbide, prior to the preparation of said semiconductor materials.

2. A process according to Claim 1, wherein said semiconductor materials are selected from a group consisting of (i) semiconductor silicon; and (ii) a precursor silane of semiconductor silicon.

3. A process according to Claim 2, wherein said semiconductor material is semiconductor silicon.

4. A process according to Claim 2, wherein said semiconductor material is a precursor silane of semiconductor silicon, said precursor silane being selected from a group consisting of silane, dichlorosilane, trichlorosilane, tetrachlorosilane and disilane.

5. A process according to Claim 3, wherein said semiconductor silicon is prepared by decomposing a precursor silane of said semiconductor silicon with hydrogen in a vapor state and depositing semiconductor silicon on a heated substrate of semiconductor silicon, said substrate being at a temperature greater than about $700°C.$, wherein the precursor silane is selected from a group consisting of silane, dichlorosilane, trichlorosilane, tetrachlorosilane and disilane.

6. A process according to Claim 4, wherein the precursor silane is prepared by reacting tetrachlorosilane with hydrogen at temperatures of greater than about $600°C.$ to produce trichlorosilane.

7. A process according to Claim 1, wherein treating carbonaceous surfaces with silicon carbide comprises coating said carbonaceous surfaces with an essentially non-porous layer of silicon carbide.

8. A semiconductor material produced in a reactor system, the carbonaceous surfaces of said reactor system which come into contact with a hydrogen environment at temperatures of greater than about $500°C.$ during preparation of said semiconductor material being treated with silicon carbide, prior to the preparation of said semiconductor material.

9. A semiconductor material according to Claim 8, wherein said semiconductor material is selected from a group consisting of (i) semiconductor silicon, and (ii) a precursor silane of semiconductor silicon.

10. A semiconductor material according to Claim 9, wherein said semiconductor material is semiconductor silicon.

11. A semiconductor material according to Claim 9, wherein said semiconductor material is a precursor silane of semiconductor silicon, said precursor silane being selected from a group consisting of silane, dichlorosilane, trichlorosilane, tetrachlorosilane and disilane.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE - A1 - 2 641 723 (WACKER-CHEMITRONIC GESELLSCHAFT FÜR ELEKTRONIK-GRUNDSTOFFE MBH) <br> * Claims; page 2, lines 1-12 * | 1-3,7-10 | C 01 B 33/02 <br> C 30 B 25/00 <br> C 23 C 16/32 <br> H 01 L 21/205 |
| X | FR - A1 - 2 236 962 (TOSHIBA CERAMICS CO.) <br> * Claims; page 1, lines 1-33 * | 1-3,7-10 | |
| D,X | DE - A1 - 2 739 258 (WACKER-CHEMITRONIC GESELLSCHAFT FÜR ELEKTRONIK-GRUNDSTOFFE MBH) <br> * Claims; page 4, lines 1-25 * | 1-3,7-10 | |

---

**TECHNICAL FIELDS SEARCHED (Int. Cl.4)**

C 01 B
C 30 B
H 01 L
C 23 C
C 04 B
H 05 B

The present search report has been drawn up for all claims

| Place of search | Date of completion of the search | Examiner |
|---|---|---|
| VIENNA | 18-08-1988 | PAMMINGER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82